# EUROPÄISCHE PATENTSCHRIFT

(11) **EP 3 736 674 B1**
(45) Veröffentlichungstag und Bekanntmachung des Hinweises auf die Patenterteilung: **11.06.2025**
(21) Anmeldenummer: 20172287.3
(22) Anmeldetag: 30.04.2020
(51) Int. Cl.: G06F 3/045, H03K 17/96, H01H 13/703, H01H 13/785

(54) **BEDIENVORRICHTUNG ZUR FUNKTIONSSTEUERUNG VON HAUSHALTSGERÄTEN**
OPERATING DEVICE FOR OPERATING HOUSEHOLD APPLIANCES
DISPOSITIF DE COMMANDE DESTINÉ À LA COMMANDE FONCTIONNELLE DES APPAREILS ÉLECTROMÉNAGERS

(30) Priorität: 08.05.2019 DE 102019206632
(43) Veröffentlichungstag der Anmeldung: 11.11.2020
(73) Patentinhaber: BSH Hausgeräte GmbH, 81739 München (DE)
(72) Erfinder: Sattler, Guido, 14612 Falkensee (DE); Schlaß, Alexander, 14624 Dallgow-Döberitz (DE)

(56) Entgegenhaltungen:
- EP-A1- 3 495 927
- EP-A2- 2 182 636
- WO-A1-2018/025334
- DE-A1- 102011 077 896

## Beschreibung

Die vorliegende Erfindung betrifft eine Bedienvorrichtung zur Funktionssteuerung eines Haushaltsgeräts, ein Haushaltsgerät sowie ein Verfahren zum Herstellen einer Bedienvorrichtung.

Für die Funktionssteuerung von Haushaltsgeräten werden Bedienvorrichtungen eingesetzt. Eine Bedienvorrichtung ist üblicherweise an einer Blende des Haushaltsgeräts befestigt. Derartige Bedienvorrichtungen weisen beispielsweise Drehkörper, Tasten oder Touchdisplays für eine manuelle Auswahl von Funktionen des Haushaltsgeräts auf. Hierdurch können neben der Auswahl von Funktionen auch Einstellungen, wie beispielsweise Auswahl von Programmen, vorgenommen sowie das Haushaltsgerät aktiviert oder deaktiviert werden.

Insbesondere bei mechanisch ausgeführten Bedienvorrichtungen, welche Tasten oder Drehwähler aufweisen, erfolgt die Funktionssteuerung durch Ausbilden von elektrischen Kontakten oder durch Betätigen von Schaltern. Hierzu ist üblicherweise eine elektrische Schaltung auf der Blende des Haushaltsgeräts verschraubt. Die Tasten oder Drehwähler wirken somit auf die elektrischen Kontakte oder Schalter, die auf der elektrischen Schaltung angeordnet sind. Bedingt durch den Aufbau einer derartigen Bedieneinheit mit mehreren schichtweise aufgebauten Komponenten kann ein Einhalten von vorgegebenen Toleranzen bei der Herstellung der Bedienvorrichtung problematisch sein.

Darüber hinaus werden in der Regel für jedes Bedienkonzept, wie beispielsweise basierend auf Tasten, Drehwählern, Jog-Dials, auf das jeweilige Bedienkonzept angepasste Blenden, elektrische Schaltungen und Befestigungsvorrichtungen bei der Herstellung des Haushaltsgeräts verwendet. Somit ist für jedes Bedienkonzept mindestens eine spezielle Bestückungsvariante notwendig.

Beispielsweise ist in der EP 3 495 927 A1 eine Bedieneinheit für ein Haushaltsgerät, insbesondere eine Klimaanlage, offenbart. Die Bedieneinheit ist als resistives Touchscreen ausgebildet.

Ein weitere Bedieneinheit für ein Haushaltsgerät mit einem druckempfindlichen, resisitvien Sensor ist in der EP 2 182 636 A2 offenbart.

Es ist die Aufgabe der vorliegenden Erfindung, die Nachteile aus dem Stand der Technik zu beseitigen und eine Bedienvorrichtung zu schaffen, welche die Anzahl an notwendigen Komponenten bei unterschiedlichen Bedienkonzepten senken und die Einhaltung von Toleranzen begünstigen kann.

Gemäß einer erfindungsgemäßen Ausführungsform wird eine Bedienvorrichtung zur Funktionssteuerung eines Haushaltsgeräts mit den Merkmalen vom Anspruch 1 bereitgestellt.

Die Leiterplatte kann beispielsweise als eine elektrisch leitfähig beschichtete Folie, als eine elektrisch leitfähige Folie, ein elektrisch leitfähig beschichteter Kunststoff oder eine Beschichtung auf einer elektrischen Leiterplatine bzw. Schaltung ausgestaltet sein. Insbesondere kann die Leiterplatte hochohmig ausgeführt sein, wodurch der elektrische Widerstand der Leiterplatte über eine gesamte Länge der Leiterplatte beispielsweise zumindest 1 kOhm beträgt. Die Membran kann somit niederohmig ausgeführt sein. Beispielsweise kann die Membran einen elektrischen Widerstand über eine Gesamtlänge der Membran von beispielsweise 0,01 bis 200 Ohm aufweisen. In einer alternativen Ausgestaltung kann die Membran hochohmig und die Leiterplatte niederohmig ausgeführt sein. Je nach Ausprägung können auch abweichende Widerstände der Membran und der Leiterplatte eingestellt werden. Insbesondere kann der elektrische Widerstand der Membran und der Leiterplatte auch gleich sein.

Die Membran ist vorzugsweise elastisch oder flexibel ausgeführt, sodass der Stößel die Membran lokal verformen und gegen die Leiterplatte drücken kann. Da die Membran und die Leiterplatte zueinander ausgerichtete elektrische Beschichtungen aufweisen oder elektrisch leitfähig sind, wird durch den mindestens einen Stößel die elektrisch leitfähige Verbindung zwischen der Leiterplatte und der Membran ausgebildet. Nach dem Entfernen des Stößels verformt sich die Membran vorzugsweise in einen ursprünglichen Zustand und unterbricht somit selbstständig die durch den Stößel hergestellte elektrische Verbindung.

Die Membran und die Leiterplatte weisen vorzugsweise feste elektrische Abgriffe, welche direkt oder über elektrische Leitungen mit einer Auswerteelektronik verbindbar sind. Über die elektrischen Abgriffe kann durch die Auswerteelektronik eine Widerstandmessung durchgeführt werden. Abhängig von der Position des Stößels bzw. einer Wirkposition des Stößels ist eine unterschiedliche Weglänge zwischen den elektrischen Abgriffen und somit ein unterschiedlicher Widerstand über die ausgebildete elektrische Verbindung messbar.

Der Stößel ist vorzugsweise durch eine Feder gespannt in der Bedieneinheit angeordnet und ragt der Membrananordnung zugewandt aus der Bedieneinheit hinaus. Alternativ oder zusätzlich kann die Bedieneinheit federnd gelagert sein. Je nach Ausgestaltung kann der mindestens eine Stößel auch fest in der Bedieneinheit verbaut sein oder als ein aus der Bedieneinheit hinausragender Abschnitt ausgeprägt sein. Durch eine federnde Lagerung des Stößels kann eine Anpresskraft des Stößels auf die Membran sichergestellt werden. Des Weiteren können durch eine derartige Lagerung des Stößels Fertigungsabweichungen und Fertigungstoleranzen ausgeglichen werden.

Die Membran kann vorzugsweise direkt auf oder in der Bedienblende des Haushaltsgeräts befestigt werden. Damit ist die Auswerteelektronik nicht mehr Bestandteil der Toleranzkette bei der Umsetzung der Bedienvorrichtung und der Programmwahl. Eine derartige Bedienvorrichtung kann mit einer Vielzahl an unterschiedlichen Bedieneinheiten eingesetzt werden. Beispielsweise kann die Bedieneinheit als eine oder mehrere Tasten, als Drehschalter, Drehwähler, Jog-Dial und dergleichen ausgeführt sein. Somit kann die Bedienvorrichtung bei einer Vielzahl von unterschiedlichen Komponenten eingesetzt werden, wodurch die Notwendigkeit unterschiedlicher Bedienvorrichtungen entfällt. Bei unterschiedlichen Bedienkonzepten können insbesondere die Bedieneinheiten unterschiedlich ausgestaltet sein, die übrigen Komponenten können übergreifend eingesetzt werden.

Durch die erfindungsgemäße Bedienvorrichtung kann eine kostengünstige Lösung für mechanisch betätigbare Bedienkonzepte bereitgestellt werden. Insbesondere kann die Bedienvorrichtung in standardisierter Form und/oder modular in der Bedienblende für verschiedene Bedienkonzepte verwendbar sein. Darüber hinaus kann durch die Bedienvorrichtung ein vereinfachtes mechanisches Interface zwischen elektronischen Bauteilen und Kunststoffteilen im Bedienmodul bzw. der Bedienblende des Haushaltsgeräts umgesetzt werden. Die Platzierung der Bedienelemente am Haushaltsgerät kann nahezu unabhängig von der Auswerteelektronik und der Membrananordnung erfolgen.

Aufgrund einer Reduzierung der Toleranzkette kann ein taktiles Verhalten der Bedieneinheiten optimiert werden. Weitere Vorteile ergeben sich durch eine variierbare Ausführungsmöglichkeit der Bedieneinheiten, da der Stößel als einziges funktionales Element in der Bedieneinheit eingebracht sein kann.

Abhängig von der Ausführung der Membrananordnung ist ein verbesserter Spritzschutz und Berührungsschutz realisierbar, da die Membrananordnung technisch einfach hermetisch abgedichtet werden kann.

Erfindungsgemäß ist der mindestens eine Stößel entlang einer Ausdehnung der Membran verschiebbar ausgestaltet. Hierzu kann die mindestens eine Bedieneinheit den Stößel entlang der Membrananordnung verschieben. Die mindestens eine Bedieneinheit kann beispielsweise als ein Drehknopf, Drehschalter, Druckschalter, Schiebeschalter, Jog-Dial, und dergleichen ausgeführt sein.

Eine derartige Bedieneinheit kann als ein Drehwähler, Drehschalter, Schieberegler und dergleichen ausgeführt sein. Hierdurch kann eine fließende bzw. stetige Änderung des elektrischen Widerstands durch das Einwirken des Stößels erzielt werden. Insbesondere kann der Stößel hierbei kontinuierlich auf die Membran einwirken oder erst durch zusätzliche Druckausübung auf das Bedienelement auf die Membran pressbar sein.

Die Membrananordnung kann beispielsweise eine Linie oder zumindest einen Ringabschnitt ausformen, entlang welchem der Stößel durch die Bedieneinheit bewegt wird. Alternativ kann die Membrananordnung ringförmig, rechteckig, vieleckig, oval und dergleichen ausgebildet sein.

Gemäß einer weiteren alternativen oder zusätzlichen Ausführungsform weist der mindestens eine Stößel eine feste Position relativ zu der Membran auf. Durch diese Maßnahme kann die mindestens eine Bedieneinheit als ein oder mehrere Taster oder Knöpfe ausgeführt sein. Somit kann die Bedienvorrichtung technisch besonders einfach ausgeführt sein. Insbesondere kann hierbei eine gleiche Membrananordnung, wie bei einer als Drehschalter ausgeführten Bedieneinheit eingesetzt werden, wodurch eine Bauteilvielfalt und somit die Kosten für die Herstellung der Bedienvorrichtung weiter gesenkt werden. Bei einer Bedieneinheit mit einer festen Position kann der Stößel durch Drücken der Bedieneinheit auf die Membran gepresst werden, um eine elektrische Verbindung zwischen der Membran und der Leiterplatte auszubilden.

Die Bedienung der Bedienvorrichtung für einen Benutzer kann haptisch aufgewertet werden, wenn die als Drehknopf, Drehschalter oder Schieber ausgeführte Bedieneinheit in vordefinierten Drehpositionen einrastbar ist. Vorzugsweise können eine Lagerung sowie eine Rastpositionierung der Bedienvorrichtung direkt zwischen einer Blende und der Bedieneinheit umgesetzt werden. Hierdurch können die technische Komplexität der Bedienvorrichtung und ein Montageaufwand der Bedienvorrichtung verringert werden.

Vorteilhafterweise ist die als Drehknopf oder Drehschalter ausgeführte Bedieneinheit entlang einer Rotationsachse um 360° unbeschränkt oder entlang eines Winkelbereichs beschränkt drehbar. Hierdurch kann zusätzliche eine Designfreiheit bei der Konstruktion der Bedienvorrichtung bereitgestellt werden. Hierzu kann die Membrananordnung eine nahezu vollständige Ringform aufweisen, welche an einer Position für einen elektrischen Abgriff durch die Auswerteeinheit unterbrochen ist. Die Auswerteeinheit kann vorzugsweise ein endseitiges Verlassen des Stößels von der Membrananordnung und ein erneutes Einwirken auf die Membrananordnung an einem entgegengesetzten Ende der Membrananordnung detektieren und in Form von Funktionen oder einer Programwahl auswerten können.

Nach einer weiteren Ausführungsform weist die als Drehschalter ausgestaltete Bedieneinheit mindestens einen zweiten Stößel auf. Bevorzugterweise ist die Bedieneinheit zum Herstellen einer zweiten elektrischen Verbindung zwischen der Membran und der Leiterplatte durch den zweiten Stößel axial drückbar. Durch diese Maßnahme kann eine zweite Funktion durch die mindestens eine Bedieneinheit ausgelöst werden. Vorzugsweise weist hierzu die Membran und/oder die Leiterplatte zwei elektrische Abgriffe für die Messung des elektrischen Widerstands durch die Auswerteeinheit. Hierdurch kann ein elektrischer Widerstand der elektrisch leitfähigen Verbindung beidseitig eines Stößels ermittelt werden, wobei jeweils beidseitig des Stößels mindestens ein weiterer durch Stößel durch Druckausübung auf die Bedieneinheit auf die Membran einwirken kann, um weitere durch die Auswerteeinheit messbare Widerstandsänderungen zu verursachen.

Vorzugsweise sind die Membran und/oder die Leiterplatte zumindest an einer Position mit einer Auswerteeinheit zum Messen und Verarbeiten von elektrischen Widerständen elektrisch verbindbar. Dies kann durch die elektrischen Abgriffe an der Membrananordnung erfolgen. Die elektrischen Abgriffe stellen jeweils einen elektrischen Kontakt zu einem elektrisch leitfähigen Teil der Membran und einem elektrisch leitfähigen Teil der Leiterplatte her. Hierzu können die elektrischen Abgriffe als Lötverbindungen, Steckverbindungen oder Klemmverbindungen ausgeführt sein.

Die Bedienvorrichtung kann besonders vielseitig und flexibel hergestellt werden, wenn die Membrananordnung linear, radial, ringförmig oder als ein Ringabschnitt geformt ist. Insbesondere kann eine Form der Membrananordnung einer Form des Haushaltsgerätes, einer Form der mindestens einen Bedieneinheit und/oder einer Bewegungstrajektorie der mindestens einen Bedieneinheit entsprechen bzw. folgen.

Gemäß einem weiteren Aspekt der Erfindung wird ein Haushaltsgerät, insbesondere ein Trockner, eine Waschmaschine oder ein Herd, bereitgestellt. Das Haushaltsgerät weist mindestens eine Bedienvorrichtung gemäß einem der vorherigen Ansprüche aufweist. Darüber hinaus kann das Haushaltsgerät als ein Staubsauger, eine Mikrowelle, ein Backofen und dergleichen ausgeführt sein.

Durch den Einsatz einer derartigen Bedienvorrichtung in dem Haushaltsgerät können unterschiedliche Bedienkonzepte auf einer einheitlichen Auswerteelektronik bzw. Auswerteeinheit sowie einer Membrananordnung basieren. Hierdurch kann die Anzahl der benötigten Komponenten reduziert werden, da Haushaltsgeräte mit Tasten, Jog-Dials, Drehschaltern und dergleichen mit einer gleichen Membrananordnung und Auswerteeinheit bedienbar sind.

Das Haushaltsgerät kann besonders kosteneffizient hergestellt werden, wenn eine Membrananordnung der Bedienvorrichtung in eine Blende des Haushaltsgeräts integriert oder auf der Blende befestigt ist. Insbesondere kann die Leiterplatte der Membrananordnung auf die Blende aufgeklebt, aufgedampft oder aufgeschmolzen werden. Durch eine derartige Integration der Leiterplatte in die Blende des Haushaltsgeräts können Fertigungstoleranzen reduziert werden, da zusätzliche Befestigungsvorrichtungen zum Aufnehmen von Schaltern oder elektrischen Kontakten entfallen können.

Nach einem weiteren Aspekt der Erfindung wird ein Verfahren nach Anspruch 10 bereitgestellt.

Hierdurch bildet die mindestens eine Bedieneinheit mit der Blende eine zusammenhängende Komponente aus. Die Membrananordnung kann durch die Integration der Leiterplatte ebenfalls als Bestandteil der Blende ausgebildet sein.

Durch das Verfahren wird die Blende des Haushaltsgeräts sowohl für die Positionierung der Bedieneinheit als auch für die Ausbildung der Leiterplatte und damit der Membrananordnung verwendet. Durch eine derartige Mehrfachverwendung kann die Blende des Haushaltsgeräts besonders effizient genutzt werden.

Die Erfindung sowie das technische Umfeld werden nachfolgend anhand der Figuren näher und durch die Ansprüche definiert.
- Fig. 1: zeigt eine Draufsicht auf eine Bedienvorrichtung gemäß einer ersten Ausführungsform.
- Fig. 2: zeigt eine Schnittdarstellung der Bedienvorrichtung aus Fig. 1.
- Fig. 3: zeigt eine Draufsicht auf eine Bedienvorrichtung gemäß einer zweiten Ausführungsform.
- Fig. 4: zeigt eine Schnittdarstellung der Bedienvorrichtung aus Fig. 3.
- Fig. 5: zeigt eine Draufsicht auf eine Bedienvorrichtung gemäß einer dritten Ausführungsform.
- Fig. 6: zeigt eine Schnittdarstellung der Bedienvorrichtung aus Fig. 5.

In den Figuren sind gleiche oder einander entsprechende Elemente mit den gleichen Bezugszeichen gekennzeichnet. Faktoren wie beispielsweise numerische Werte, Formen, Komponenten, Positionen von Komponenten und die Weise, wie die Komponenten miteinander verbunden sind, sind lediglich illustrativ und nicht einschränkend. In den Zeichnungen sind aus Gründen der Übersicht und zur Verbesserung der Erkennbarkeit teilweise unterschiedliche Maßstäbe verwendet.

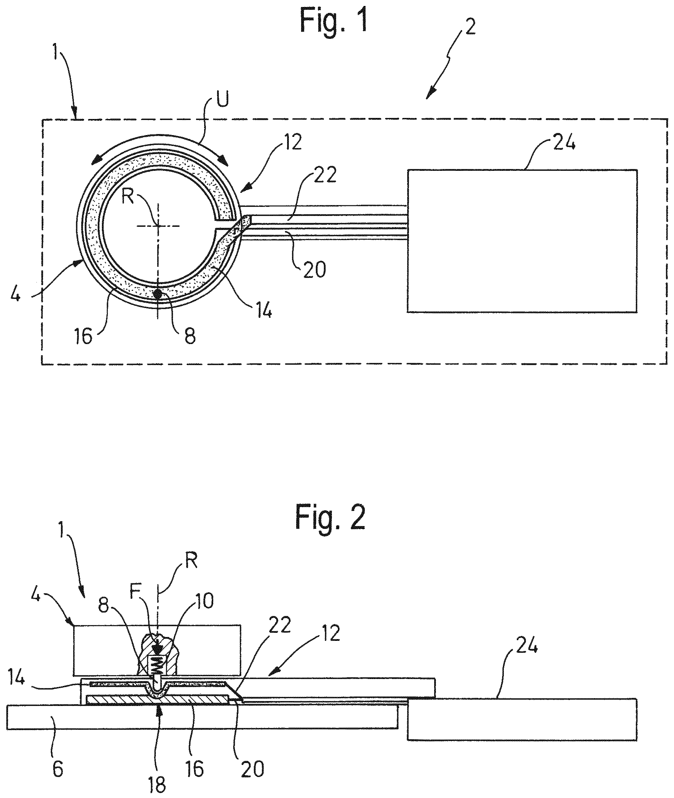

Fig. 1 zeigt eine Frontansicht einer erfindungsgemäßen Drehwählervorrichtung 1, die auf der äußeren Oberfläche eines erfindungsgemäßen Haushaltsgerätes, in Form einer Waschmaschine 2, angeordnet ist. Die Drehwählervorrichtung 1 umfasst einen Drehkörper.

Fig. 1 zeigt eine Draufsicht auf eine Bedienvorrichtung 1 gemäß einer ersten Ausführungsform. Die Bedienvorrichtung 1 ist auf einer äußeren Oberfläche eines Haushaltsgerätes 2 angeordnet, welches beispielsweise als ein Herd oder als eine Waschmaschine ausgestaltet ist. In Fig. 2 ist zur Veranschaulichung eine Schnittdarstellung der Bedienvorrichtung 1 aus Fig. 1 dargestellt.

Die Bedienvorrichtung 1 dient zur Funktionssteuerung des Haushaltsgerätes 2 und weist eine Bedieneinheit 4 auf. Die Bedieneinheit 4 ist gemäß dem Ausführungsbeispiel als ein Drehwähler ausgeführt. Die Bedieneinheit 4 ist zylindrisch geformt und ist entlang einer Rotationsachse R drehbar an einer Blende 6 des Haushaltsgeräts 2 gelagert.

An der Bedieneinheit 4 ist ein Stößel 8 angeordnet. Der Stößel 8 ragt in Richtung der Blende 6 aus der Bedieneinheit 4 hinaus und ist mittels einer Feder 10 gelagert.

Der Stößel 8 wird durch die Feder 10 mit einer Federkraft F gegen eine Membrananordnung 12 gepresst. Die Membrananordnung 12 ist auf der Blende 6 befestigt und verläuft somit zwischen der Bedieneinheit 4 und der Blende 6.

Die Membrananordnung 12 weist eine Membran 14 und eine Leiterplatte 16 auf. Die Membran 14 und die Leiterplatte 16 sind im Wesentlichen ringförmig ausgeführt, sodass der Stößel 8 während einer Umdrehung U der Bedieneinheit 4 stets auf die Membrananordnung 12 einwirken kann. Die Leiterplatte 16 ist geringfügig breiter als die Membran 14 ausgeführt. Insbesondere in Fig. 2 ist die voneinander beabstandete Anordnung der Membran 14 und der Leiterplatte 16 verdeutlicht.

Die Membran 14 und die Leiterplatte 16 weisen jeweils eine elektrisch leitfähige Beschichtung auf. Die Membran 14 ist elastisch verformbar ausgeführt und kann durch den federgelagerten Stößel 8 derart verformt werden, dass zwischen der Membran 14 und der Leiterplatte 16 eine elektrisch leitfähige Verbindung 18 ausgebildet wird. Die Membran 14 ist aus einer elastischen Folie hergestellt und weist eine niederohmige elektrisch leitfähige Beschichtung auf. Die Leiterplatte 16 ist als eine starre Folie ausgeführt und weist eine hochohmige elektrisch leitfähige Beschichtung auf.

Gemäß dem Ausführungsbeispiel übt der Stößel 8 dauerhaft mit der Federkraft F einen Druck auf die Membran 14 aus, wodurch an einem Punkt der Membrananordnung 12 stets eine elektrisch leitfähige Verbindung 18 ausgebildet ist. Durch Drehen U der Bedieneinheit 4 kann die Position des Stößels 8 entlang der Membrananordnung 12 und somit der elektrisch leitfähigen Verbindung 18 variiert werden.

Über jeweils einen elektrischen Abgriff 20, 22 sind die Membran 14 und die Leiterplatte 16 elektrisch mit einer Auswerteeinheit 24 verbunden. Die Auswerteeinheit 24 ist dazu eingerichtet einen elektrischen Widerstand einer Wegstrecke zwischen den beiden elektrischen Abgriffen 20, 22 über die elektrisch leitfähige Verbindung 18 zu messen. Der elektrische Widerstand ändert sich abhängig von der Wegstrecke und damit auch abhängig von der Position des Stößels 8. Des Weiteren ist die Auswerteeinheit 24 dazu eingerichtet, anhand des ermittelten elektrischen Widerstands eine Funktion, eine Programmauswahl, ein Aktivieren, ein Deaktivieren, eine Eigenschaft und dergleichen des Haushaltsgeräts 2 auszuführen. Durch den über die Position des Stößels 8 eingestellten und durch die Auswerteeinheit 24 ermittelten elektrischen Widerstand kann somit eine Steuerung des Haushaltsgeräts 2 realisiert werden.

Die Auswerteeinheit 24 kann basierend auf diskreten elektronischen Komponenten oder basierend auf µControllern aufgebaut sein.

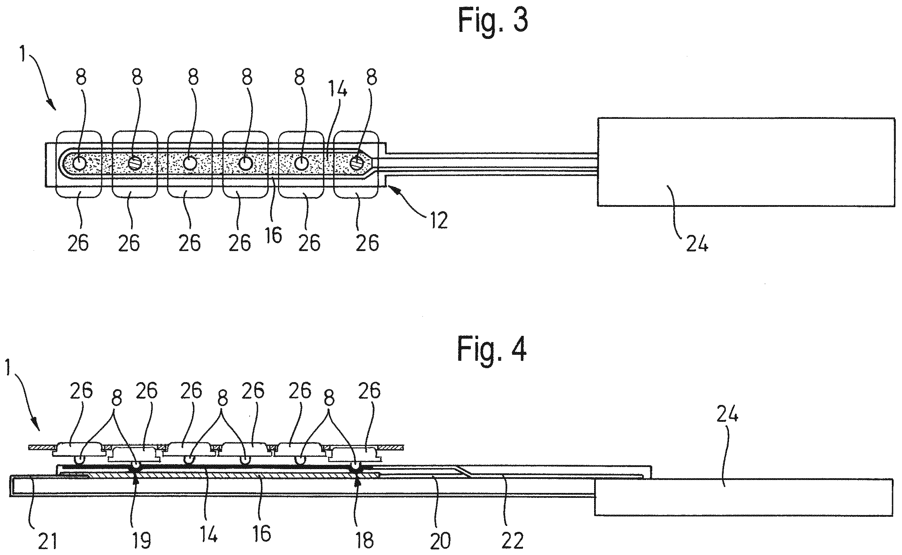

In Fig. 3 ist eine Draufsicht auf eine Bedienvorrichtung 1 gemäß einer zweiten Ausführungsform gezeigt. Analog hierzu zeigt Fig. 4 eine Schnittdarstellung der Bedienvorrichtung 1 aus Fig. 3. Im Unterschied zum ersten Ausführungsbeispiel, weist die Bedienvorrichtung 1 mehrere Bedieneinheiten 26 auf, welche als Taster oder Knöpfe ausgeführt sind.

Die Membrananordnung 12 ist gemäß dieser Ausführungsform an eine Anordnung der Bedieneinheiten 26 linear geformt. Des Weiteren ist die Leiterplatte 16 beidseitig elektrisch über jeweils einen endseitig angeordneten Abgriff 20, 21 mit der Auswerteeinheit 24 verbunden. Hierdurch kann der elektrische Widerstand von zwei Seiten der Membrananordnung 12 aus ermittelt werden. Durch eine derartige dreipolige Ausgestaltung der Membrananordnung 12 können zwei elektrisch leitfähige Verbindungen 18, 19 festgestellt und der jeweilige elektrische Widerstand gemessen werden.

In der dargestellten Ausführungsform sind die Bedieneinheiten 26 in einer initialen Ausgangsposition nicht gedrückt, wodurch der Stößel 8 keine Einwirkung auf die Membran 14 ausübt. Hierbei ist der Stößel 8 starr ausgestaltet und integral mit der jeweiligen Bedieneinheit 26 ausgeformt. Zum Vermeiden von Beschädigungen der Membrananordnung 12 kann der Stößel 8 und/oder die Bedieneinheit 26 aus einem elastisch verformbaren Material, wie beispielsweise Gummi, Elastomer, Silikon und dergleichen, bestehen. Die Bedieneinheiten 26 können hierbei auch einteilig als eine flächige Tastenreihe oder mehrteilig als einzelne Tasten ausgestaltet sein. Wird eine Bedieneinheit 26 gedrückt, wird der jeweilige Stößel 8 gegen die Membran 14 derart gedrückt, dass eine elektrisch leitfähige Verbindung 18, 19 zwischen der Membran 14 und der Leiterplatte 16 hergestellt wird. Die Bedieneinheiten 26 können in einer gedrückten Position einrastend ausgeführt sein.

Die dargestellte Bedienvorrichtung 1 kann mehrere Reihen an Bedieneinheiten 26 und mehrere Reihen an Membrananordnungen 12 bzw. Membrananordnungen 12 mit mehreren Membranen 14 und Leiterplatten 16 aufweisen. Die Membrananordnung 12 und die Anordnung der Bedieneinheiten 26 kann auch für beliebig andere geometrischen Figuren, beispielsweise winkelförmig, geschwungen, kreisförmig, mehreckig und dergleichen angepasst werden.

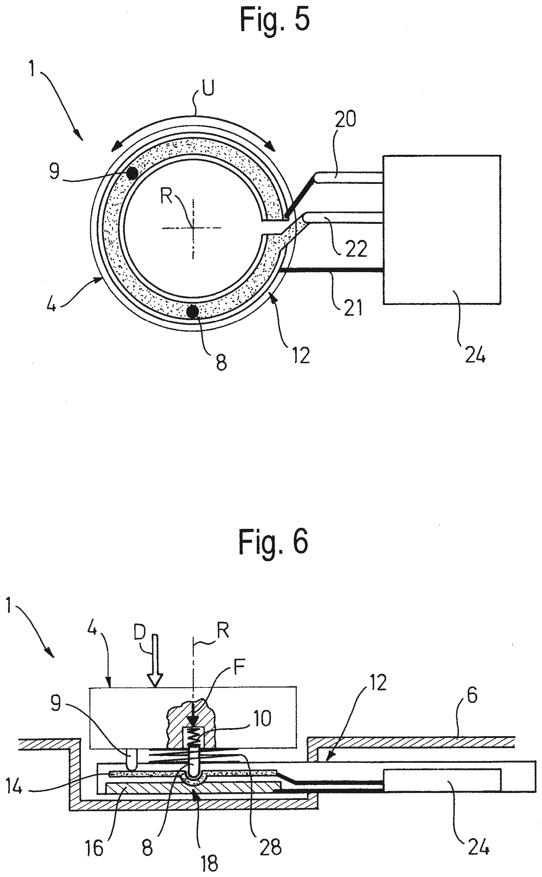

Fig. 5 zeigt eine Draufsicht auf eine Bedienvorrichtung 1 gemäß einer dritten Ausführungsform. In Fig. 6 ist eine entsprechende Schnittdarstellung der Bedienvorrichtung 1 aus Fig. 5 verdeutlicht. Durch Mehrfachauswertung einer Winkelposition können zusätzliche Funktionen über die Bedienvorrichtung 1 umgesetzt werden. Analog zur Bedienvorrichtung 1 gemäß dem ersten Ausführungsbeispiel ist die Bedieneinheit 4 als ein Drehwähler ausgeführt. Zusätzlich kann die Bedieneinheit 4 axial entlang der Rotationsachse R gegen die Membrananordnung 12 gedrückt werden.

Neben einem ersten Stößel 8 weist die Bedieneinheit 4 einen zweiten Stößel 9 auf. Der erste Stößel 8 übt zum Herstellen einer ersten elektrisch leitfähigen Verbindung 18 dauerhaft Druck auf die Membran 14 aus.

Der zweite Stößel 9 ist von der Membrananordnung 12 axial entlang der Rotationsachse R beabstandet. Die Bedieneinheit 4 kann durch zusätzliche Krafteinwirkung D eines Benutzers als Taster eingesetzt werden. Die Pfeile veranschaulichen die Krafteinwirkung D. Im gedrückten Zustand der Bedieneinheit 4 übt zusätzlich zum ersten Stößel 8 auch der zweite Stößel 9 Druck auf die Membran 14 aus und stellt somit eine zweite elektrische Verbindung 19 zwischen der Membran 14 und der Leiterplatte 19 her.

Zum Detektieren von mehreren elektrischen Verbindungen 18, 19 weist die Leiterplatte 16 analog zur Fig. 4 zwei endseitige elektrische Abgriffe 20, 21 auf.

Ein Federelement 28 kann hierbei die Bedieneinheit 4 in einer axialen Ruheposition halten. Die Blende 6 kann hierfür die entsprechende Gegenkraft aufbringen. Durch Drücken auf den Programmwähler bzw. die Bedieneinheit 4 wirkt der mindestens eine zweite Stößel 9 zusätzlich auf die Membran 14 ein. Der zweite Stößel 9 ist vorzugsweise entsprechend des gewünschten Betätigungshubs kürzer als ein Arbeitspunkt des ersten Stößels 8 ausgeführt.

Gemäß dem Ausführungsbeispiel ist der erste Stößel 8 von dem zweiten Stößel 9 beabstandet. Der Abstand zwischen den Stößeln 8, 9 beträgt beispielsweise 120°.

Gemäß einer Ausgestaltung kann der mindestens eine Stößel 8, 9 anstatt einer separaten Feder 10 einen integrierten Federabschnitt aufweisen oder aus einem elastisch verformbaren Material bestehen.

### Bezugszeichenliste

- 1: Bedienvorrichtung
- 2: Haushaltsgerät
- 4: Bedieneinheit / Drehwähler
- 6: Blende des Haushaltsgeräts
- 8: erster Stößel
- 9: zweiter Stößel
- 10: Feder
- 12: Membrananordnung
- 14: Membran
- 16: Leiterplatte
- 18: erste elektrisch leitfähige Verbindung
- 19: zweite elektrisch leitfähige Verbindung
- 20: erster elektrischer Abgriff der Leiterplatte
- 21: zweiter elektrischer Abgriff der Leiterplatte
- 22: elektrischer Abgriff der Membran
- 24: Auswerteeinheit
- 26: Bedieneinheit / Taster bzw. Knopf
- 28: Federelement der Bedieneinheit

- F: Anpresskraft des Stößels
- D: Krafteinwirkung eines Benutzers
- R: Rotationsachse
- U: Drehrichtung der Bedieneinheit

## Patentansprüche

1. Bedienvorrichtung (1) zur Funktionssteuerung eines Haushaltsgeräts (2), aufweisend mindestens eine Bedieneinheit (4)
mit mindestens einem Stößel (8, 9),
und aufweisend mindestens eine Membrananordnung (12) mit einer zumindest einseitig elektrisch leitfähigen Membran (14)
und einer elektrisch leitfähigen Leiterplatte (16), welche parallel zu der Membran (14) verläuft und von der Membran (14) beabstandet ist,
wobei die Membran (14) zum Herstellen von mindestens einer elektrisch leitfähigen Verbindung (18, 19) durch den mindestens einen Stößel (8, 9) der Bedieneinheit (4) gegen die Leiterplatte (16) pressbar ist,
wobei der mindestens eine Stößel (8, 9) entlang einer Ausdehnung der Membran (14) verschiebbar ausgestaltet ist, und
wobei eine Funktion durch einen messbaren elektrischen Widerstand oder eine Widerstandsänderung der elektrisch leitfähigen Verbindung (18, 19) einstellbar ist.

2. Bedienvorrichtung nach Anspruch 1, wobei der mindestens eine Stößel (8, 9) eine feste Position relativ zu der Membran (14) aufweist.

3. Bedienvorrichtung nach Anspruch 2, wobei die als Drehknopf, Drehschalter oder Schieber ausgeführte Bedieneinheit (4) in vordefinierten Drehpositionen einrastbar ist.

4. Bedienvorrichtung nach Anspruch 2 oder 3, wobei die als Drehknopf oder Drehschalter ausgeführte Bedieneinheit (4) entlang einer Rotationsachse (R) um 360° unbeschränkt oder entlang eines Winkelbereichs beschränkt drehbar ist.

5. Bedienvorrichtung nach einem der Ansprüche 2 bis 4, wobei die als Drehschalter ausgestaltete Bedieneinheit (4) mindestens einen zweiten Stößel (9) aufweist, wobei die Bedieneinheit (4) zum Herstellen einer zweiten elektrischen Verbindung (19) zwischen der Membran (14) und der Leiterplatte (16) durch den zweiten Stößel (9) axial drückbar ist.

6. Bedienvorrichtung nach einem der Ansprüche 1 bis 5, wobei die Membran (14) und/oder die Leiterplatte (16) zumindest an einer Position mit einer Auswerteeinheit (24) zum Messen und Verarbeiten von elektrischen Widerständen elektrisch verbindbar sind.

7. Bedienvorrichtung nach einem der Ansprüche 1 bis 6, wobei die Membrananordnung (12) linear, radial, ringförmig oder als ein Ringabschnitt ausgebildet ist.

8. Haushaltsgerät (2), insbesondere ein Trockner, eine Waschmaschine oder ein Herd, welches mindestens eine Bedienvorrichtung (1) gemäß einem der vorherigen Ansprüche aufweist.

9. Haushaltsgerät nach Anspruch 8, wobei eine Membrananordnung (12) der Bedienvorrichtung (1) in eine Blende (6) des Haushaltsgeräts (2) integriert oder auf der Blende (6) befestigt ist.

10. Verfahren zum Herstellen der Bedienvorrichtung (1) nach Anspruch 1, wobei eine Blende (6) des Haushaltsgeräts (2) bereitgestellt wird, ein Abschnitt der Blende (6) mit einer elektrisch leitfähigen Schicht zum Ausbilden einer Leiterplatte (16) einer Membrananordnung (12) versehen wird, eine von der Leiterplatte (16) beabstandete Membran (14) an der Blende (6) angeordnet wird und mindestens eine Bedieneinheit (4, 26) mit einem gegen die Membran (14) pressbaren Stößel (8, 9) in einen Aufnahmeabschnitt der Blende (6) eingesetzt wird, wobei der mindestens eine Stößel (8, 9) entlang einer Ausdehnung der Membran (14) verschiebbar ausgestaltet ist.

## Claims

1. Operating device (1) for operating a household appliance (2), having at least one operating unit (4)
with at least one plunger (8, 9),
and having at least one diaphragm arrangement (12) with a diaphragm (14) which is electrically conductive on at least one side
and an electrically conductive circuit board (16) which runs parallel to the diaphragm (14) and is spaced from the diaphragm (14),
wherein the diaphragm (14) can be pressed against the circuit board (16) for producing at least one electrically conductive connection (18, 19) by way of the at least one plunger (8, 9) of the operating unit (4),
wherein the at least one plunger (8, 9) is configured such that it can be moved along an extension of the diaphragm (14), and
wherein a function can be adjusted by way of an electrical resistance which can be measured or by way of a change in the resistance of the electrically conductive connection (18, 19).

2. Operating device according to claim 1, wherein the at least one plunger (8, 9) has a fixed position in relation to the diaphragm (14).

3. Operating device according to claim 2, wherein the operating unit (4) embodied as a rotary knob, rotary switch or slider can be engaged in predefined rotary positions.

4. Operating device according to claim 2 or 3, wherein the operating unit (4) embodied as a rotary knob or rotary switch can be rotated along an axis of rotation (R) by 360° in an unrestricted manner or along an angular region in a restricted manner.

5. Operating device according to one of claims 2 to 4, wherein the operating unit (4) embodied as a rotary switch has at least one second plunger (9), wherein the operating unit (4) can be axially pressed by way of the second plunger (9) to produce a second electrical connection (19) between the diaphragm (14) and the circuit board (16).

6. Operating device according to one of claims 1 to 5, wherein the diaphragm (14) and/or the circuit board (16) can be electrically connected to an evaluation unit (24) for measuring and processing electrical resistances at least at one position.

7. Operating device according to one of claims 1 to 6, wherein the diaphragm arrangement (12) is designed in a linear, radial or annular manner or as a ring section.

8. Household appliance (2), in particular a dryer, a washing machine or a cooker, which has at least one operating device (1) according to one of the preceding claims.

9. Household appliance according to claim 8, wherein a diaphragm arrangement (12) of the operating device (1) is integrated in a panel (6) of the household appliance (2) or is fastened to the panel (6).

10. Method for producing the operating device (1) according to claim 1, wherein a panel (6) of the household appliance (2) is provided, a section of the panel (6) is provided with an electrically conductive layer to form a circuit board (16) of a diaphragm arrangement (12), a diaphragm (14) spaced from the circuit board (16) is arranged on the panel (6) and at least one operating unit (4, 26) with a plunger (8, 9) which can be pressed against the diaphragm (14) is inserted into a receiving section of the panel (6), wherein the at least one plunger (8, 9) is configured such that it can be moved along an extension of the diaphragm (14).

## Revendications

1. Dispositif de commande (1) destiné à la commande fonctionnelle d'un appareil électroménager (2), présentant au moins une unité de commande (4) avec au moins un poussoir (8, 9), et présentant au moins un dispositif formant membrane (12) avec une membrane (14) électriquement conductrice au moins d'un côté et une carte de circuits imprimés (16) électriquement conductrice, laquelle passe parallèlement à la membrane (14) et est espacée de la membrane (14),
dans lequel la membrane (14) pour produire au moins une liaison électriquement conductrice (18, 19) peut être pressée contre la carte de circuits imprimés (16) par le au moins un poussoir (8, 9) de l'unité de commande (4),
dans lequel le au moins un poussoir (8, 9) est conçu de manière à pouvoir coulisser le long d'une extension de la membrane (14), et
dans lequel une fonction peut être réglée par une résistance électrique mesurable ou une modification de résistance de la liaison électriquement conductrice (18, 19).

2. Dispositif de commande selon la revendication 1, dans lequel le au moins un poussoir (8, 9) présente une position fixe par rapport à la membrane (14).

3. Dispositif de commande selon la revendication 2, dans lequel l'unité de commande (4) réalisée comme un bouton rotatif, un interrupteur rotatif ou un curseur peut être encliquetée dans la position de rotation prédéfinie.

4. Dispositif de commande selon la revendication 2 ou 3, dans lequel l'unité de commande (4) réalisée comme un bouton rotatif ou un interrupteur rotatif peut tourner d'une manière rotative de façon illimitée à 360° le long d'un axe de rotation (R) ou de façon limitée le long d'une zone angulaire.

5. Dispositif de commande selon l'une des revendications 2 à 4, dans lequel l'unité de commande (4) configurée comme un interrupteur rotatif présente au moins un deuxième poussoir (9), dans lequel l'unité de commande (4) pour produire une deuxième liaison électrique (19) peut être pressée axialement entre la membrane (14) et la carte de circuits imprimés (16) par le deuxième poussoir (9).

6. Dispositif de commande selon l'une des revendications 1 à 5, dans lequel la membrane (14) et/ou la carte de circuits imprimés (16) peuvent être reliées électriquement au moins à une position avec une unité d'évaluation (24) pour mesurer et traiter des résistances électriques.

7. Dispositif de commande selon l'une des revendications 1 à 6, dans lequel le dispositif formant membrane (12) est conçu linéaire, radial, circulaire ou comme une section annulaire.

8. Appareil électroménager (2), plus particulièrement un séchoir, un lave-linge ou une cuisinière, lequel présente au moins un dispositif de commande (1) selon l'une des revendications précédentes.

9. Appareil électroménager selon la revendication 8, dans lequel un dispositif formant membrane (12) du dispositif de commande (1) est intégré dans un panneau (6) de l'appareil électroménager (2) ou est fixé sur le panneau (6).

10. Procédé de fabrication du dispositif de commande (1) selon la revendication 1, dans lequel un panneau (6) de l'appareil électroménager (2) est mis à disposition, une section du panneau (6) est dotée d'une couche électriquement conductrice pour former une carte de circuits imprimés (16) d'un dispositif formant membrane (12), une membrane (14) espacée de la carte de circuits imprimés (16) est disposée sur le panneau (6) et au moins une unité de commande (4, 26) est insérée dans une section de logement du panneau (6) avec un poussoir (8, 9) pouvant être poussé contre la membrane (14), dans lequel le au moins un poussoir (8, 9) est conçu de manière à pouvoir coulisser le long d'une extension de la membrane (14).
